# EUROPÄISCHE PATENTANMELDUNG

(11) **EP 0 545 493 A2**
(43) Veröffentlichungstag der Anmeldung: **09.06.1993**
(21) Anmeldenummer: 92203690.0
(22) Anmeldetag: 30.11.1992
(51) Int. Cl.: G11C 7/00, H03K 3/037

(54) **Abtastschaltung**

(30) Priorität: 29.11.1991 DE 4139340
(71) Anmelder: Philips Patentverwaltung GmbH, 22335 Hamburg (DE); Philips Electronics N.V., 5621 BA Eindhoven (NL)
(72) Erfinder: Bayer, Ludwig, Dr., W-2000 Hamburg 1 (DE); Behrens, Michael, Dr., W-2000 Hamburg 1 (DE)
(74) Vertreter: Volmer, Georg, Dipl.-Ing.

(57) **Zusammenfassung**

Die Erfindung bezieht sich auf eine Abtastschaltung zur Erzeugung einer Folge von Abtastwerten eines binären Signals für ein Ausgangssignal. In der Abtastschaltung enthaltene Speichermittel (4 bis 7; 28, 29) sind zur Speicherung von aufeinanderfolgenden Abtastwerten des binären Signals vorgesehen, wobei die Dauer zwischen zwei aufeinanderfolgenden Signalwechseln des binären Signals größer ist als die Zeit der aufeinanderfolgenden Abtastwerte. Des weiteren ist in der Abtastschaltung eine mit den Speichermittln (4 bis 7; 28, 29) gekoppelten Testschaltung (22 bis 25; 27, 30 bis 40) enthalten, die bei Gleichheit der Abtastwerte einer ersten Folge der aufeinanderfolgenden Abtastwerte zur Lieferung eines Abtastwertes der ersten Folge für das Ausgangsssignal vorgesehen ist und bei Ungleichheit der Abtastwerte der ersten Folge entweder bei Gleichheit einer zweiten Folge der aufeinanderfolgenden Abtastwerte zur Lieferung eines Abtastwertes der zweiten Folge für das Ausgangssignal vorgesehen ist oder zur Lieferung eines vorgegebenen Abtastwertes als Ausgangssignal vorgesehen ist.

## Beschreibung

Die Erfindung bezieht sich auf eine Abtastschaltung zur Erzeugung einer Folge von Abtastwerten eines binären Signals für ein Ausgangssignal.

Eine solche Abtastschaltung wird beispielsweise in einer Schnittstellenschaltung eingesetzt, die ein binäres Signal empfängt. Die Schnittstellenschaltung führt eine Anpassung an den Takt der nachfolgenden Schaltung durch. Hierbei wird in einem bistabilen Kippglied bzw. Latch (Speicherelement) eine Speicherung des Zustandes des binären Signals durchgeführt. Ein solches bistabiles Kippglied weist in seiner Eingangsstufe komplementäre Transistoren (z.B. CMOS-Inverter) auf. Das binäre Signal wird dabei jeweils beim Auftreten einer Flanke eines der Schaltungsanordnung zugeführten Taktsignals abgetastet. Das Taktsignal (das abtastende Signal) und das binäre Signal (das abzutastende Signal), die nominell die gleichen Frequenzen aufweisen sollen, haben eine sehr geringe Frequenzabweichung, die sich in der Regel außerdem über eine längere Zeitdauer gesehen verändern kann.

Wenn das binäre Signal beim Wechsel des Signalpegels abgetastet wird, können im Kippglied undefinierte und metastabile Zustände auftreten. Während eines metastabilen Zustandes ist der Signalpegel nicht eindeutig "0" oder "1".

Um einen metastabilen Zustand in der Eingangsstufe eines bistabilen Kippgliedes zu vermeiden, ist aus der Veröffentlichung "Control metastability in high-speed CMOS circuits" von T. Bowns, Electronic Design, 26.09.1991, Seiten 74 bis 80, insbesondere Seite 78, linke Spalte, dritter Absatz, bekannt, zwei oder drei Kippglieder seriell zusammenzuschalten. Das wird als mehrstufige Synchronisation bezeichnet. Wenn das erste Kippglied in einen metastabilen Zustand geht, wird dieser Zustand sich wahrscheinlich auflösen, bevor das nächste Kippglied getaktet wird.

Der Erfindung liegt die Aufgabe zugrunde, eine Abtastschaltung der eingangs genannten Art zu schaffen, die metastabile Zustände in einem nachfolgenden Speicherelement verhindert.

Die Erfindung wird durch eine Abtastschaltung zur Erzeugung einer Folge von Abtastwerten eines binären Signals für ein Ausgangssignal durch folgende Merkmale gelöst:
Die Abtastschaltung enthält Speichermittel zur Speicherung von aufeinanderfolgenden Abtastwerten des binären Signals, wobei die Dauer zwischen zwei aufeinanderfolgenden Signalwechseln des binären Signals größer ist als die Zeit der aufeinanderfolgenden Abtastwerte, und
eine mit den Speichermitteln gekoppelten Testschaltung, die bei Gleichheit der Abtastwerte einer ersten Folge der aufeinanderfolgenden Abtastwerte zur Lieferung eines Abtastwertes der ersten Folge für das Ausgangsssignal vorgesehen ist und bei Ungleichheit der Abtastwerte der ersten Folge entweder bei Gleichheit einer zweiten Folge der aufeinanderfolgenden Abtastwerte zur Lieferung eines Abtastwertes der zweiten Folge für das Ausgangssignal vorgesehen ist oder zur Lieferung eines vorgegebenen Abtastwertes als Ausgangssignal vorgesehen ist.

In der erfindungsgemäßen Abtastschaltung wird ein Ausgangssignal erzeugt, welches zuerst in Speichermitteln nach einer Abtastung gespeichert worden ist. Ein nachfolgendes Speicherelement kann dann nicht in einen metastabilen Zustand gelangen. Die Speichermittel können z.B. aus mehreren bistabilen Kippgliedern bestehen, die eine Eingangsstufe aus komplementären Transistoren, z.B. CMOS-Inverter, enthalten können.

Es werden aufeinanderfolgende Abtastwerte des binären Signals nach mehreren Abtastungen in dem Speichermittel gespeichert. Die Abtastwerte einer ersten Folge der aufeinanderfolgenden Abtastwerte werden verglichen. Sind die Abtastwerte gleich, wird einer der Abtastwerte für das Ausgangssignal verwendet. Hat beispielsweise ein Wechsel des Signalpegels zwischen zwei Abtastungen oder während einer Abtastung stattgefunden, sind die Abtastwerte ungleich und ein Abtastwert wird nicht als Ausgangssignal verwendet. Wenn die Abtastwerte der ersten Folge ungleich sind, wird entweder ein weiterer Vergleich mit einer zweiten Folge von Abtastwerten oder ein vorgegebener Wert als Ausgangssignal ausgegeben. Sind die Abtastwerte der zweiten Folge gleich, wird als Ausgangssignal ein Abtastwert dieser zweiten Folge verwendet.

Die Abtastungen bilden einen Abtastzyklus, dessen Dauer kleiner sein muß, als die Dauer zwischen zwei Signalwechseln des abzutastenden binären Signals. Die zeitlichen Abstände der Abtastungen können äquidistant gewählt sein und z.B. aus dem Taktsignal der Abtastschaltung abgeleitet sein.

Ein metastabiler Zustand, der in den Speichermitteln auftreten kann, wird durch die erfindungsgemäßen Maßnahmen nicht weitergereicht.

Eine erste Ausführungsform der erfindungsgemäßen Abtastschaltung enthält Speichermittel mit vier Speicherelementen jeweils zur Speicherung eines Abtastwertes von vier aufeinanderfolgenden Abtastungen. Nach dem Vergleich der Abtastwerte der ersten und zweiten Abtastung und der Abtastwerte der dritten und vierten Abtastung ist eine in der Testschaltung enthaltene Steuerschaltung zur Lieferung eines Abtastwertes für das Ausgangssignal vorgesehen ist.

Bei der zweiten Ausführungsform ist des weiteren vorgesehen, daß eine Freigabeschaltung aufeinanderfolgend zur Freigabe jeweils eines der vier Speicherelemente dient, daß zum Vergleich der Abtastwerte der ersten und zweiten Abtastung und der Abtastwerte der dritten und vierten Abtastung zwei in der Testschaltung enthaltene Vergleicher mit den Ausgängen der Speicherelemente gekoppelt sind und daß die Steuerschaltung zur Steuerung eines in der Testschaltung Multiplexers vorgesehen ist, der zur Kopplung des Ausgangs des Speicherelementes, welches zur Speicherung des Abtastwertes der ersten Abtastung dient, oder zur Kopplung des Ausgangs des Speicherelementes, welches zur Speicherung des Abtastwertes der dritten Abtastung dient, mit dem Eingang eines weiteren Speicherelementes bestimmt ist.

Eine zweite Ausführungsform der erfindungsgemäßen Schaltungsanordnung enthält Speichermittel mit zwei Speicherelementen jeweils zur Speicherung von entweder zwei oder vier aufeinanderfolgenden Abtastungen. Die Testschaltung weist entweder einem ersten oder zweiten Vergleichszustand auf. In einem ersten Vergleichszustand ist die Testschaltung zur Freigabe der Speicherelemente zur Speicherung von zwei Abtastwerten einer ersten und zweiten Abtastung, bei Gleichheit der Abtastwerte der ersten und zweiten Abtastung zur Lieferung eines Abtastwertes der ersten und zweiten Abtastung als Ausgangssignal und bei Ungleichhheit der beiden Abtastwerte der ersten und zweiten Abtastung zum Wechsel in einen zweiten Vergleichszustand und zur Freigabe der Speicherelemente für zwei weitere Abtastwerte einer dritten und vierten Abtastung vorgesehen. In dem zweiten Vergleichszustand ist die Testschaltung zur Freigabe der Speicherelemente zur Speicherung von zwei Abtastwerten einer dritten und vierten Abtastung, bei Gleichheit der Abtastwerte der dritten und vierten Abtastung zur Lieferung eines Abtastwertes der dritten und vierten Abtastung als Ausgangssignal, bei Ungleichheit der beiden Abtastwerte der dritten und vierten Abtastung zum Wechsel in den ersten Vergleichszustand und zur Lieferung des vorgegebenen Abtastwertes als Ausgangssignal vorgesehen.

Im ersten Vergleichszustand werden zuerst die Abtastwerte der ersten und zweiten Abtastung verglichen. Wenn die Abtastwerte der ersten und zweiten Abtastung ungleich sind, werden die Abtastwerte der dritten und vierten Abtastung verglichen. Wie oben erwähnt, weichen die Frequenzen des abzutastenden binären Signals und des Abtastsignals nur geringfügig voneinander ab. Unter dieser Voraussetzung ist die Wahrscheinlichkeit sehr groß, daß die Abtastwerte der ersten und zweiten Abtastung beim nächsten Abtastzyklus ebenfalls ungleich sind. Daher verbleibt die Testschaltung in einem zweiten Vergleichszustand, in dem nur die Abtastwerte der dritten und vierten Abtastung verglichen werden. Bei dieser Ausführungsform wird während der Zeitpunkte, an denen ein erster und zweiter Abtastwert auftritt, keine Speicherung vorgenommen.

Wenn sich ergibt, daß die Abtastwerte der dritten und vierten Abtastung ungleich sind, werden nicht die Signalwerte der ersten und zweiten Abtastung wieder miteinander verglichen, sondern zuerst ein vorgegebener Wert (Füllwert) als Ausgangssignal ausgegeben. Hiermit wird erreicht, daß nicht zweimal hintereinander ein möglicher fehlerhafter Abtastwert ausgegeben wird.

Bei der zweiten Ausführungsform ist des weiteren vorgesehen, daß der Ausgang des ersten Speicherelementes mit dem Eingang des zweiten Speicherelementes und die Ausgänge beider Speicherelemente mit einer in der Testschaltung enthaltenen Steuerschaltung gekoppelt sind, daß die Steuerschaltung zur Lieferung eines Abtastwertes an ein weiteres Speicherelement und eines Sperrsignals an eine in der Testschaltung enthaltene Freigabeschaltung dient und daß die Freigabeschaltung bei Vorliegen eines ersten Sperrwertes zur Sperrung der Speicherelemente bei der ersten und zweiten Abtastung und bei Vorliegen eines zweiten Sperrwertes zur Sperrung der Speicherelemente bei der dritten und vierten Abtastung eingerichtet ist.

Bei beiden Ausführungsformen können die Speicherelemente als bistabile Kippglieder ausgebildet sein.

Ausführungsbeispiele der Erfindung werden nachstehend anhand der Fig. näher erläutert. Es zeigen:
Fig. 1 und 4 zwei Ausführungsbeispiele einer Abtastschaltung,
Fig. 2 eine Eingabestufe von in den Ausführungsformen nach Fig. 1 und 4 verwendeten Eingangs- bzw. Ausgangs-Kippgliedern und
Fig. 3 Signalabläufe zur Erläuterung der Funktionsweise der Ausführungsformen nach Fig. 1 und 4.

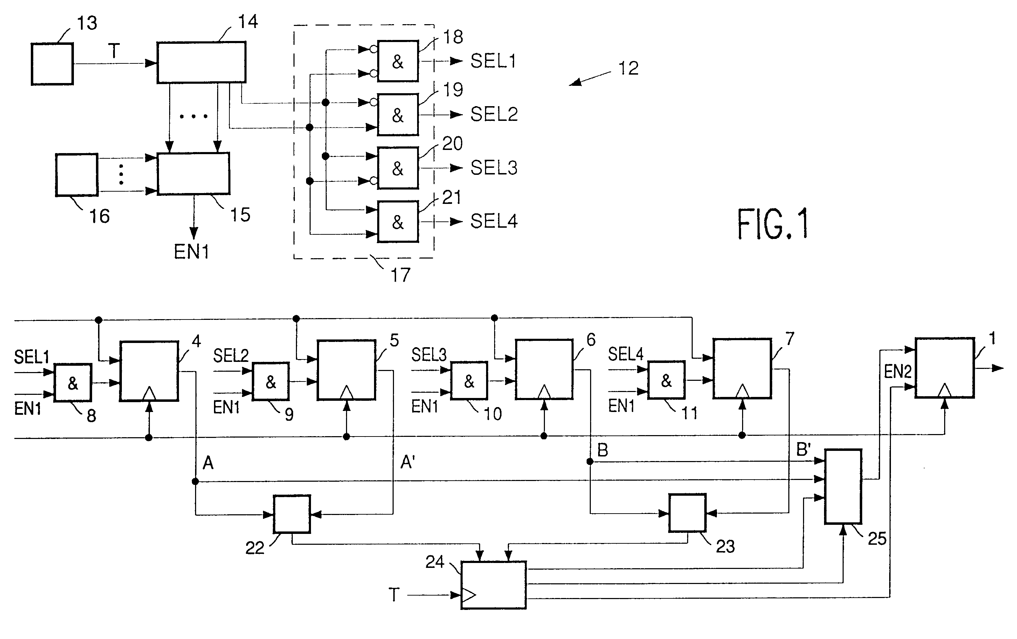

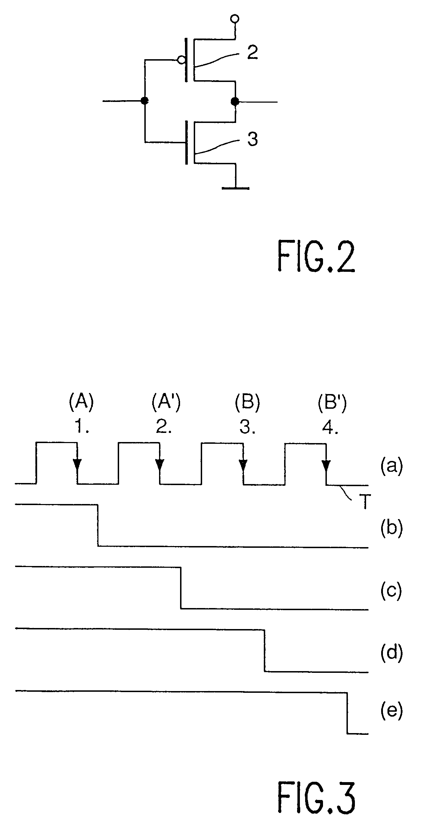

Die in Fig. 1 dargestellte Abtastschaltung enthält ein bistabiles Ausgangs-Kippglied 1 (Speicherelement), in dem Abtastwerte gespeichert werden. Ein solches Ausgangs-Kippglied 1 speichert einen an seinem Eingang anliegenden Abtastwert, wenn ein Freigabesignal und die wirksame Flanke eines Taktsignales vorliegt. Mit einer kurzen Zeitverzögerung steht der Abtastwert am Ausgang des Ausgangs-Kippgliedes 1 zur Verfügung. Ein solches Ausgangs-Kippglied 1 enthält in seiner Eingangsstufe zwei komplementäre Transistoren (CMOS-Transistor) 2 und 3 (Fig. 2). Der Gate-Anschluß des N-Kanal-Feldeffekttransistors 2 und der Gate-Anschluß des P-Kanal-Feldeffekttransistors 3 sind miteinander verbunden und bilden den Eingang des Ausgangs-Kippgliedes 1. Der Source-Anschluß des Transistors 2 und der Drain-Anschluß des Transistors 3 sind zusammengeschaltet und bilden den Anschluß an weitere Stufen des Ausgangs-Kippgliedes 1. Der Source-Anschluß des Transistors 3 ist noch an Masse und der Drain-Anschluß des Transistors 2 an eine Spannungsversorgung angeschlossen.

Bei einer solchen Eingangsstufe können metastabile Zustände auftreten. Ein metastabiler Zustand tritt auf, wenn die wirksame Flanke eines Taktsignals genau beim Signalwechsel (Zustandsänderung) von "0" auf "1" oder umgekehrt auftritt.

Zur Verhinderung eines metastabilen Zustandes im Ausgangs-Kippglied 1 weist die Schaltungsanordnung vier bistabile Eingangs-Kippglieder 4 bis 7 (Speicherelemente) auf, die ebenfalls zwei komplementäre Transistoren enthalten. Das Signal wird jedem Eingang eines Eingangs-Kippgliedes 4 bis 7 und ein Taktsignal T wird jedem Takteingang der Eingangs-Kippglieder 4 bis 7 zugeführt. Der Freigabeeingang jedes Eingangs-Kippgliedes 4 bis 7 ist mit einem UND-Gatter 8 bis 11 verbunden, die jeweils Signale von einer Freigabeschaltung 12 erhalten.

Die Freigabeschaltung 12 umfaßt einen Taktgenerator 13, einen Zähler 14, einen Vergleicher 15, einen Festwertspeicher 16 und einen Dekoder 17 mit vier UND-Gattern 18 bis 21. Der Taktgenerator 13 liefert das Taktsignal T an den Zähleingang des Zählers 14. Die beiden niederwertigsten Ausgänge des Zählers sind mit dem Dekoder 17 verbunden. Die restlichen höherwertigen Ausgänge des Zählers 14 weisen Verbindungen mit Eingängen des Vergleichers 15 auf. Andere Eingänge des Vergleichers 15 sind mit Ausgängen des Festwertspeichers 16 gekoppelt. Der Vergleicher 15 gibt ein Freigabesignal EN1 aus, wenn der vom Zähler 14 gelieferte Wert mit dem Speicherwert im Festwertspeicher 16 identisch ist.

Die beiden niederwertigsten Ausgänge des Zählers 14 sind mit jeweils zwei Eingängen jedes UND-Gatters 18 bis 21 gekoppelt. Der niederwertigste Ausgang des Zählers 14 ist mit einem invertierenden Eingang des UND-Gatters 18, mit einem invertierenden Eingang des UND-Gatters 19, mit einem nichtinvertierenden Eingang des UND-Gatters 20 und mit einem nichtinvertierenden Eingang des UND-Gatters 21 verbunden. Der andere Ausgang des Zählers 14 ist an einen anderen invertierenden Eingang des UND-Gatters 18, an einen nichtinvertierenden Eingang des UND-Gatters 19, an den einen invertierenden Eingang des UND-Gatters 20 und an den anderen nichtinvertierenden Eingang des UND-Gatters 21 angeschlossen. Die Ausgänge der UND-Gatter 18 bis 21 liefern Auswahlsignale SEL1 bis SEL4.

Zu einem Eingang jedes UND-Gatters 8 bis 11 wird das Freigabesignal EN1 geführt. Zu dem zweiten Eingang des UND-Gatter 8 wird zusätzlich noch das Auswahlsignal SEL1, zu dem zweiten Eingang des UND-Gatters 9 das Auswahlsignal SEL2, zu dem zweiten Eingang des UND-Gatters 10 das Auswahlsignal SEL3 und zu dem zweiten Eingang des UND-Gatters 11 das Auswahlsignal SEL4 geführt. Durch die Freigabeschaltung 12 wird bewirkt, daß in den Eingangs-Kippgliedern 4 bis 7 nacheinander Abtastwerte abgespeichert werden.

Beträgt beispielsweise die Dauer zwischen zwei Signalwechseln des binären Signals 125 µs und die Taktfrequenz des Taktgenerators 13 40 MHz, dann beträgt die Zählergröße 13 Bit. Der im Festwertspeicher 16 gespeicherte Wert kann dezimal 4999 ("1001110001") betragen. Hat der Zähler den dezimalen Wert 4999 erreicht, wird er auf 0 zurückgesetzt.

Die Ausgänge der Eingangs-Kippglieder 4 und 5 sind mit Eingängen eines Vergleichers 22 und die Ausgänge der Eingangs-Kippglieder 6 und 7 mit Eingängen eines Vergleichers 23 verbunden. Der Ausgang jedes Vergleichers 22 und 23 ist mit einer Steuerschaltung 24 gekoppelt, die beispielsweise ein Mikroprozessor sein kann. Der Steuerschaltung 24 wird ebenfalls das Taktsignal T geliefert. Die Steuerschaltng 24 kann nach dem folgenden Ablauf arbeiten: 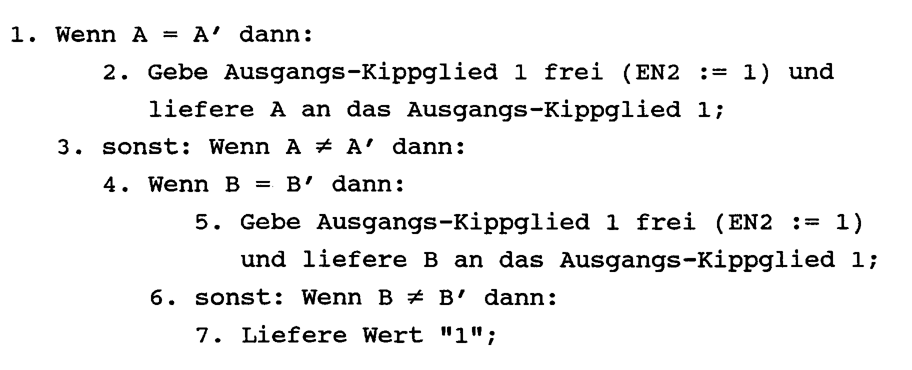
Wenn der Abtastwert A des Eingangs-Kippgliedes 4 gleich dem Abtastwert A' des Eingangs-Kippgliedes 5 ist, wird von der Steuerschaltung 24 ein Freigabesignal EN2 für das Ausgangs-Kippglied 1 erzeugt. Des weiteren wird ein Multiplexer 25 so gesteuert, daß der Ausgang des Eingangs-Kippgliedes 4 mit dem Eingang des Ausgangs-Kippgliedes 1 verbunden ist. Wenn die beiden Abtastwerte A und A' ungleich sind, und der Abtastwert B des Eingangs-Kippgliedes 6 gleich dem Abtastwert B' des Eingangs-Kippgliedes 7 ist, wird das Freigabesignal EN2 dem Ausgangs-Kippglied 1 zugeführt und der Multiplexer 25 so gesteuert, daß der Ausgang des Eingangs-Kippgliedes 6 mit dem Eingang des Ausgangs-Kippgliedes 1 verbunden ist. Wenn der Abtastwert B ungleich dem Abtastwert B' ist, dann wird ein vorgegebener Wert, beispielsweise der logische Wert "1", von der Steuerschaltung 24 über den Multiplexer 25 zum Ausgangs-Kippglied 1 geliefert. Die Vergleicher 22 und 23, die Steuerschaltung 24 und der Multiplexer 25 sind Schaltungselemente einer Testschaltung.

Die Funktionsweise der Abtastschaltung nach Fig. 1 kann auch mit Hilfe der in Fig. 3 dargestellten Signale (a) bis (e) erläutert werden. Das Signal (a) zeigt das Taktsignal T, welches mit vier Impulsen dargestellt ist. Die wirksame Flanke des Taktsignales T ist die rückwärtige Flanke. Das Signal (b) weist einen Signalwechsel zwischen der ersten und zweiten Abtastung auf. Somit stellt die Steuerschaltung 24 fest, daß der Abtastwert A und der Abtastwert A' ungleich sind und die Abtastwerte B und B' gleich sind. Das Signal (c) weist einen Signalwechsel zwischen der zweiten und dritten Abtastung auf. In diesem Fall sind die Abtastwerte A und A' und die Abtastwerte B und B' identisch. Hierbei wird der Abtastwert A an das Ausgangs-Kippglied 1 geliefert. Beim nächsten Abtastzyklus, der den Zeitraum der vier Abtastungen umfaßt, liegt ein Signalwechsel des Signals (d) zwischen der dritten und vierten Abtastung vor. In diesem Fall sind die beiden Abtastwerte A und A' gleich und die Abtastwerte B und B' ungleich. Der Abtastwert A wird an das Ausgangs-Kippglied 1 von der Steuerschaltung 24 geliefert. Beim letzten Signal (e) findet der Signalwechsel nach dem Abtastzyklus, d.h. nach insgesamt vier Abtastungen statt. In diesem Fall sind die Abtastwerte A und A' und die Abtastwerte B und B' identisch. An das Ausgangs-Kippglied 1 wird der Abtastwert A geliefert.

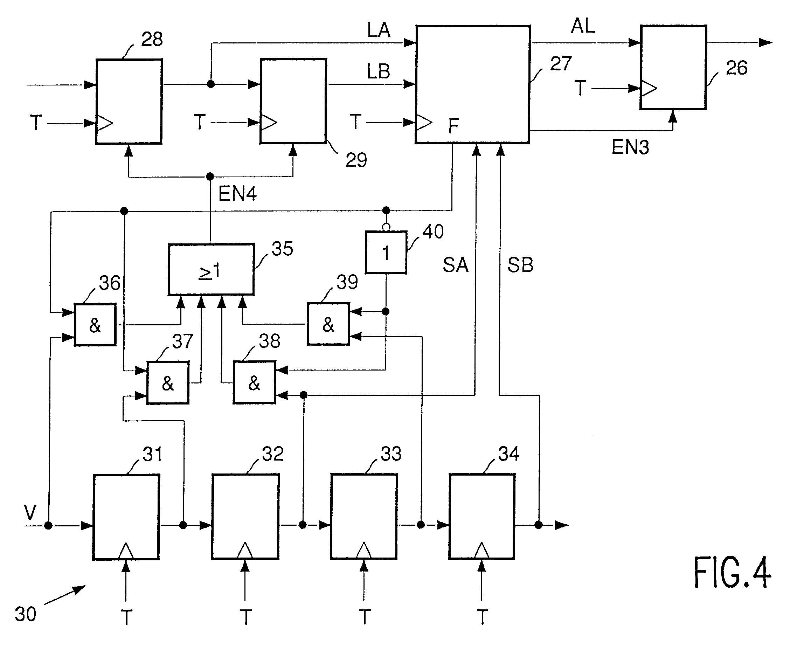

Ein zweites Ausführungsbeispiel der Abtastschaltung ist in der Fig. 4 gezeigt. Diese enthält ein Ausgangs-Kippglied 26 (Speicherelement), das ein Freigabesignal EN3 von einer Steuerschaltung 27 erhält. Der zu speichernde Abtastwert AL wird von der Steuerschaltung 27 dem Ausgangs-Kippglied 26 zugeführt. Des weiteren erhält das Ausgangs-Kippglied 26 noch ein Taktsignal T an seinen Takteingang geliefert.

Die Steuerschaltung 27 ist des weiteren noch mit den Ausgängen zweier bistabiler Eingangs-Kippglieder 28 und 29 verbunden, welche die Abtastwerte LA und LB liefern. Das Eingangs-Kippglied 28 erhält an seinem Eingang ein binäres Signal. Der Ausgang des Ausgangs-Kippgliedes 28 ist außer mit der Steuerschaltung 27 auch mit dem Eingang des Eingangs-Kippgliedes 29 verbunden. Die Freigabeeingänge der Eingangs-Kippglieder 28 und 29 sind mit einer Freigabeschaltung 30 verbunden, die ein Freigabesignal EN4 liefert. Des weiteren erhalten die Steuerschaltung 27 und die beiden Eingangs-Kippglieder 28 und 29 das Taktsignal T.

Die Freigabeschaltung 30 enthält vier in Reihe geschaltete Verzögerungs-Kippglieder 31 bis 34. Das erste Verzögerungs-Kippglied 21 in der Reihe erhält an seinem Eingang ein impulsförmiges Startsignal V mit einer Impulsdauer von 25 ns und einer Wiederholrate von 8 KHz. Der Ausgang des Verzögerungs-Kippgliedes 31 ist mit dem Eingang des Verzögerungs-Kippgliedes 32 und dessen Ausgang mit dem Eingang des Verzögerungs-Kippgliedes 33 verbunden.

An den Ausgang des Verzögerungs-Kippgliedes 33 ist noch der Eingang des Verzögerungs-Kippgliedes 34 angeschlossen. Die Takteingänge der Verzögerungs-Kippglieder 31 bis 34 erhalten noch das Taktsignal T, dessen Taktfrequenz 40 MHz beträgt.

Der Eingang des Verzögerungs-Kippgliedes 31 ist an den Eingang eines UND-Gatters 36 gelegt, dessen anderer Eingang mit einem Ausgang F der Steuerschaltung 27 verbunden ist. Die Ausgänge der Verzögerungs-Kippglieder 31 bis 33 sind jeweils mit UND-Gattern 37 bis 39 gekoppelt. Der andere Eingang des UND-Gatters 37 ist ebenfalls mit dem Ausgang F der Steuerschaltung 27 verbunden. Die jeweiligen anderen Eingänge der UND-Gatter 38 und 39 sind an einen Inverter 40 angeschlossen, dessen Eingang an den Ausgang F der Steuerschaltung gelegt ist. Die Steuerschaltung 27 liefert am Ausgang F ein Sperrsignal. Die Ausgänge der UND-Gatter 36 bis 39 sind mit einem ODER-Gatter 35 verbunden, welches das Freigabesignal EN 4 abgibt. Der Ausgang des Verzögerungs-Kippgliedes 32 liefert noch das Signal SA und der Ausgang des Verzögerungs-Kippgliedes 34 noch das Signal SB an die Steuerschaltung 27. Die Schaltelemente 30 bis 40 und die Steuerschaltung 27 bilden eine Testschaltung.

In der Freigabeschaltung 30 wird das Freigabesignal EN4 gebildet, welches die Eingangs-Kippglieder 28 und 29 freigibt, damit vier Abtastungen des Signales durchgeführt werden können. Das von der Steuerschaltung 27 gelieferte Sperrsignal am Ausgang F weist einen ersten Sperrwert auf, der gleich "1" ist, und einen zweiten Sperrwert, der gleich "0" ist. Die restliche Funktionsweise wird im folgenden mittels des unten dargestellten Ablaufes in der Steuerschaltung 27 erläutert:

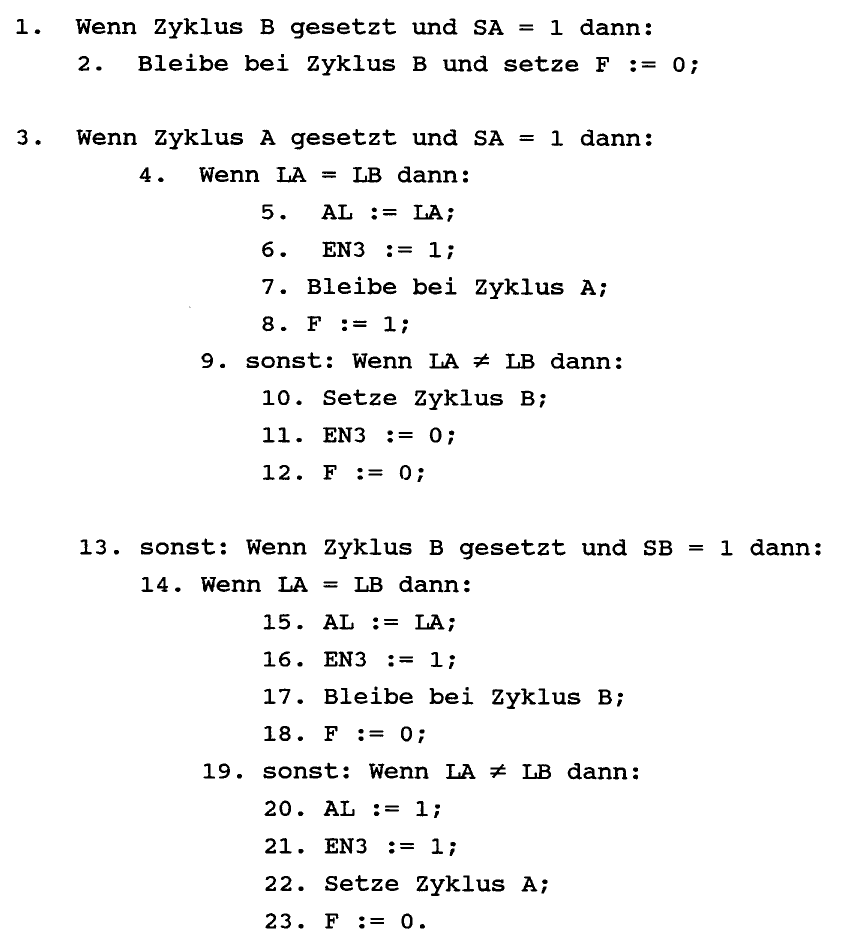

Wenn die Steuerschaltung 27 einen Zyklus A (erster Vergleichszustand) gesetzt hat, werden zuerst die in den Eingangs-Kippgliedern 28 und 29 gespeicherten Abtastwerte der ersten und zweiten Abtastung verglichen. Hat die Steuerschaltung 27 den Zyklus B (zweiter Vergleichszustand) gesetzt, werden nur die Abtastwerte der dritten und vierten Abtastung verglichen. In den beiden Eingangs-Kippgliedern 28 und 29 sind die Abtastwerte der ersten und zweiten Abtastung gespeichert, wenn der Ausgangswert des Verzögerungs-Kippgliedes 32 gleich "1" ist (SA = "1"). In den beiden Eingangs-Kippgliedern 28 und 29 sind die Abtastwerte der dritten und vierten Abtastung gespeichert, wenn der Ausgangswert des Verzögerungs-Kippgliedes 34 gleich "1" ist (SB = "1").

Zu Beginn überprüft die Steuerschaltung 27, ob der gesetzte Zyklus und die Werte SA und SB zueinander synchron sind. Es wird zuerst abgefragt, ob der Zyklus B gesetzt ist und der Wert SA gleich "1" ist. Ist dies der Fall, bleibt der Zyklus B gesetzt und der Wert am Ausgang F der Steuerschaltung 27 wird gleich "0" gesetzt. Das bedeutet, daß ein Vergleich der Abtastwerte der ersten und zweiten Abtastung nicht stattfindet und eine Speicherung in den Eingangs-Kippgliedern 28 und 29 des Abtastwertes der ersten Abtastung und des Abtastwertes der zweiten Abtastung nicht vorgenommen wird.

Ist der Zyklus A gesetzt und der Wert SA gleich "1", dann wird als nächstes überprüft, ob die Ausgangswerte LA und LB der Eingangs-Kippglieder 28 und 29 identisch sind. Ist dies der Fall, wird von der Steuerschaltung der Ausgangswert LA zum Ausgangs-Kippglied 26 geleitet (AL = LA). Dazu muß das Freigabesignal EN3 gleich "1" gesetzt werden. Der Zyklus A bleibt gesetzt und der Ausgang F der Steuerschaltung 27 liefert den Wert "1" (erster Sperrwert). Die Abtastwerte der dritten und vierten Abtastung werden nicht in die Eingangs-Kippglieder 28 und 29 geschrieben.

Wenn der Zyklus A gesetzt ist und der Wert SA gleich "1" ist und wenn die Ausgangswerte LA und LB der Eingangs-Kippglieder 28 und 29 ungleich sind, dann wird der Zyklus B gesetzt, das Freigabesignal EN3 gleich "0" und ebenfalls der Wert am Ausgang F der Steuerschaltung 27 auf den Wert "0" (zweiter Sperrwert) geschaltet. Daraufhin werden Abtastwerte der dritten und vierten Abtastung in die Eingangs-Kippglieder 28 und 29 geschrieben.

Wenn der Zyklus B gesetzt ist und der Wert SB gleich "1" ist, dann wird zuerst überprüft, ob die Ausgangswerte LA und LB identisch sind (Abtastwerte der dritten und vierten Abtastung). Ist dies der Fall, dann wird in das Ausgangs-Kippglied 26 der Ausgangswert LA geschrieben (AL = LA). Gleichzeitig wird das Freigabesignal EN3 gleich "1" gesetzt. Die Steuerschaltung 27 bleibt beim Zyklus B und verändert den Wert des Ausganges F der Steuerschaltung 27 nicht (F = "0"). Sollte der Fall eintreten, daß die beiden Ausgangswerte LA und LB der Eingangs-Kippglieder 28 und 29 ungleich sind, wenn der Zyklus B gesetzt und der Wert SB gleich "1" ist, wird ein Füllwert "1" (vorgegebener Wert) an das Ausgangs-Kippglied 26 geleitet. Das Freigabesignal EN3 wird gleichzeitig gleich "1" gesetzt und es wird in den Zyklus A zurückgekehrt. Außerdem wird noch der Wert am Ausgang F der Steuerschaltung 27 gleich "1" gesetzt. Durch die Schreibung eines Füllwertes in das Ausgangs-Kippglied 26 wird verhindert, daß möglicherweise zweimal hintereinander ein Fehlerwert abgetastet wird.

## Patentansprüche

1. Abtastschaltung zur Erzeugung einer Folge von Abtastwerten eines binären Signals für ein Ausgangssignal mit Speichermitteln (4 bis 7; 28, 29) zur Speicherung von aufeinanderfolgenden Abtastwerten des binären Signals, wobei die Dauer zwischen zwei aufeinanderfolgenden Signalwechseln des binären Signals größer ist als die Zeit der aufeinanderfolgenden Abtastwerte, und
mit einer mit den Speichermitteln (4 bis 7; 28, 29) gekoppelten Testschaltung (22 bis 25; 27, 30 bis 40), die
- bei Gleichheit der Abtastwerte einer ersten Folge der aufeinanderfolgenden Abtastwerte zur Lieferung eines Abtastwertes der ersten Folge für das Ausgangsssignal vorgesehen ist und
- bei Ungleichheit der Abtastwerte der ersten Folge
- entweder bei Gleichheit einer zweiten Folge der aufeinanderfolgenden Abtastwerte zur Lieferung eines Abtastwertes der zweiten Folge für das Ausgangssignal vorgesehen ist oder
- zur Lieferung eines vorgegebenen Abtastwertes als Ausgangssignal vorgesehen ist.

2. Abtastschaltung nach Anspruch 1,
dadurch gekennzeichnet,
daß die Speichermittel vier Speicherelemente (4 bis 7) jeweils zur Speicherung eines Abtastwertes von vier aufeinanderfolgenden Abtastungen enthalten,
daß nach dem Vergleich der Abtastwerte der ersten und zweiten Abtastung und der Abtastwerte der dritten und vierten Abtastung eine in der Testschaltung (22 bis 25) enthaltene Steuerschaltung (24) zur Lieferung eines Abtastwertes für das Ausgangssignal vorgesehen ist.

3. Abtastschaltung nach Anspruch 2,
dadurch gekennzeichnet,
daß eine Freigabeschaltung (12) aufeinanderfolgend zur Freigabe jeweils eines der vier Speicherelemente (4 bis 7) dient,
daß zum Vergleich der Abtastwerte der ersten und zweiten Abtastung und der Abtastwerte der dritten und vierten Abtastung zwei in der Testschaltung (22 bis 25) enthaltene Vergleicher (22, 23) mit den Ausgängen der Speicherelemente (4 bis 7) gekoppelt sind und
daß die Steuerschaltung (24) zur Steuerung eines in der Testschaltung (22 bis 25) Multiplexers (25) vorgesehen ist, der zur Kopplung des Ausgangs des Speicherelementes (4), welches zur Speicherung des Abtastwertes der ersten Abtastung dient, oder zur Kopplung des Ausgangs des Speicherelementes (6), welches zur Speicherung des Abtastwertes der dritten Abtastung dient, mit dem Eingang eines weiteren Speicherelementes (1) bestimmt ist.

4. Abtastschaltung nach Anspruch 1,
dadurch gekennzeichnet,
daß die Speichermittel zwei Speicherelemente (28, 29) jeweils zur Speicherung von entweder zwei oder vier aufeinanderfolgenden Abtastungen enthalten,
daß die Testschaltung (27, 30 bis 40) entweder
- in einem ersten Vergleichszustand zur Freigabe der Speicherelemente (28, 29) zur Speicherung von zwei Abtastwerten einer ersten und zweiten Abtastung,
- bei Gleichheit der Abtastwerte der ersten und zweiten Abtastung zur Lieferung eines Abtastwertes der ersten und zweiten Abtastung als Ausgangssignal und
- bei Ungleichhheit der beiden Abtastwerte der ersten und zweiten Abtastung zum Wechsel in einen zweiten Vergleichszustand und zur Freigabe der Speicherelemente (28, 29) für zwei weitere Abtastwerte einer dritten und vierten Abtastung vorgesehen ist, oder
- in dem zweiten Vergleichszustand zur Freigabe der Speicherelemente (28, 29) zur Speicherung von zwei Abtastwerten einer dritten und vierten Abtastung,
- bei Gleichheit der Abtastwerte der dritten und vierten Abtastung zur Lieferung eines Abtastwertes der dritten und vierten Abtastung als Ausgangssignal,
- bei Ungleichhheit der beiden Abtastwerte der dritten und vierten Abtastung zum Wechsel in den ersten Vergleichszustand und zur Lieferung des vorgegebenen Abtastwertes als Ausgangssignal vorgesehen ist.

5. Schaltungsanordnung nach Anspruch 6,
dadurch gekennzeichnet,
daß der Ausgang des ersten Speicherelementes (28) mit dem Eingang des zweiten Speicherelementes (29) und die Ausgänge beider Speicherelemente (28, 29) mit einer in der Testschaltung (27, 30 bis 40) enthaltenen Steuerschaltung (27) gekoppelt sind,
daß die Steuerschaltung (27) zur Lieferung eines Abtastwertes an ein weiteres Speicherelement (26) und eines Sperrsignals an eine in der Testschaltung (27, 30 bis 40) enthaltene Freigabeschaltung (30) dient und
daß die Freigabeschaltung (30) bei Vorliegen eines ersten Sperrwertes zur Sperrung der Speicherelemente (28, 29) bei der ersten und zweiten Abtastung und bei Vorliegen eines zweiten Sperrwertes zur Sperrung der Speicherelemente (28, 29) bei der dritten und vierten Abtastung vorgesehen ist.

6. Abtastschaltung nach einem der vorhergehenden Anspruche, dadurch gekennzeichnet,
daß die Speicherelemente (1, 4 bis 7; 26, 28, 29) als bistabile Kippglieder ausgebildet sind.
